# EUROPÄISCHE PATENTANMELDUNG

(11) **EP 1 328 015 A2**
(43) Veröffentlichungstag der Anmeldung: **16.07.2003**
(21) Anmeldenummer: 02026557.5
(22) Anmeldetag: 28.11.2002
(51) Int. Cl.: H01L 21/60

(54) **Verfahren zum Flip-Chip-Bonden**

(30) Priorität: 11.01.2002 DE 10201004; 07.03.2002 DE 10209915
(71) Anmelder: Hesse & Knipps GmbH, 33100 Paderborn (DE)
(72) Erfinder: Hesse, Hans, Dr.-Ing., 33106 Paderborn (DE)
(74) Vertreter: COHAUSZ DAWIDOWICZ HANNIG & PARTNER

(57) **Zusammenfassung**

Die Erfindung betrifft einen Chip / ein Substrat(1) mit mehreren Kontaktelementen/flächen (3) zur Herstellung einer elektrisch leitenden Verbindung zwischen einem Chip (1) und einem Substrat, insbesondere mittels Ultraschallverschweissung, wobei auf der dem Substrat / Chip zugewandten Seite des Chips / Substrats (1) zwischen den Kontaktelementen/-flächen (3) wenigstens bereichsweise ein, insbesondere ultraschallschweißbares, Verbindungsmaterial (2) angeordnet ist.

Die Erfindung betrifft ebenfalls ein Verfahren zum Verbinden eines Chips (1) mit einem Substrat, bei dem zwischen den Kontaktelementen (3) des Chips (1) und den korrespondierenden Kontaktelementen (3) /Kontaktflächen des Substrats eine Ultraschall-Schweissverbindung hergestellt wird, wobei mittels eines zwischen den Kontaktelementen (3) des Chips (1) und/oder zwischen den Kontaktflächen eines Substrates angeordneten Verbindungsmaterials (2) eine weitere Verbindung zwischen dem Substrat und dem Chip (1) hergestellt wird.

## Beschreibung

Die Erfindung betrifft ein Verfahren zur Herstellung einer elektrisch leitenden Verbindung zwischen einem Chip mit mehreren Kontaktelementen bzw. Kontaktflächen und einem Substrat (Flip-Chip-Montage), insbesondere mittels Einbringen von Ultraschallenergie zum Verbinden eines Chips mit einem Substrat, bei dem die elektrisch leitende Verbindung zwischen den Kontaktelementen des Flip-Chips und den korrespondierenden Kontaktelementen/Kontaktflächen des Substrats direkt als Ultraschall-Schweissverbindung hergestellt wird. Die Erfindung betrifft weiterhin den Chip und das Substrat, die beim Verfahren eingesetzt werden.

Beim Flip-Chip-Bonden haben die Kontaktelemente auf den Kontaktflächen bzw. den Bond-Pads eine typ. Höhe von 15µm - 75µm, sie werden in Form von Stud-Bumps, Solder-Bumps oder mit dem "Platingverfahren" hergestellt. Für das Ultraschall-Flip-Chip-Bonden werden vornehmlich Stud-Bumps und Kontaktelemente nach dem "Platingverfahren" verwendet. Der nach dem Bonden verbleibende Abstand bzw. Spalt zwischen dem Substrat und dem Silizium bzw. dem Chip beträgt typ. zwischen 50% - 70% der Ausgangsspaltgröße. Um Kräfte zwischen Substrat und Chip, die durch unterschiedliche Ausdehnungskoeffizienten von Substrat und Chip ("thermal mismatch") entstehen, aufnehmen zu können (die Schubspannungen würden den Chip vom Substrat lösen), ist es bekannt, durch einen zusätzlichen Kleber, der nach dem Bonden mit einer sehr feinen Nadel zwischen Chip und Substrat eingebracht wird, die mechanische Stabilität der Gesamtanordnung zu erhöhen. Dieses Verfahren wird als Unterfüllen bzw. Underfill bezeichnet.

Insbesondere bei sehr geringem Abstand zwischen Chip und Substrat und einem geringen Abstand (Pitch) zwischen den einzelnen Kontaktelementen kann dieses Underfill-Verfahren nicht mehr eingesetzt werden, da der verbleibende Spalt ein homogenes Unterfüllen mit Kleber nicht mehr zulässt.

Aufgabe der Erfindung ist es, eine Chip- bzw. Substratkonstruktion und ein Verfahren bereitszustellen, mit denen eine sichere Befestigung zwischen Chip und Trägersubstrat erreicht wird und bei dem der Prozeßschritt "Underfill" eingespart wird.

Diese Aufgabe wird dadurch gelöst, dass auf der dem Substrat zugewandten Seite des Chips zwischen den Kontaktelementen und insbesondere auf der freien Chipfläche und/oder auf der dem Chip zugewandten Seite des Substrats zwischen den Kontaktflächen und insbesondere auf der durch den Chip bedeckten restlichen Fläche wenigstens bereichsweise ein Verbindungsmaterial angeordnet ist.

Die Aufgabe wird weiterhin dadurch gelöst, dass mittels des zwischen den Kontaktelementen des Flip-Chips und/oder des zwischen den Kontaktflächen des Substrats angeordneten Verbindungsmaterials eine weitere Verbindung zwischen dem Substrat und dem Flip-Chip hergestellt wird.

Das Verbindungsmaterial dient dazu, eine sichere, den Schubspannungen standhaltende Verbindung zwischen Chip und Substrat herzustellen, um zu gewährleisten, dass bei einer thermischen Belastung der Anordnung ein Ablösen des Chips bzw. ein Aufbrechen der elektrischen Kontakte verhindert wird.

Das Verbindungsmaterial kann in einer Ausführung bevorzugt nichtleitend sein und weist unabhängig von dieser Ausführung Eigenschaften auf, die es gestatten, dass z.B. das Verbindungsmaterial als Kleber, insbesondere zweikomponentiger Kleber dient oder auch als Ultraschall-Schweissmaterial, z.B als ultraschallschweissbarer Kunststoff.

Ebenso kann es in einer anderen Ausführung vorgesehen sein, dass das Verbindungsmaterial elektrisch leitend ist und eine elektrisch leitende Verbindung zwischen dem Chip bzw. der darin angeordneten Elektronik und dem Substrat erzeugt (z.B. Flächen für GND und Spannungsversorgung).

Das Verbindungsmaterial kann nachträglich auf die o.g. Flächen eines Chips oder eines Substrates aufgebracht werden, bevorzugt wird das Verbindungsmaterial jedoch gleich im Herstellungsprozess des Chips oder des Substrates auf diesem aufgebracht. Dies kann durch einen üblichen Verfahrensschritt bei der Herstellung des Chips oder Substrats geschehen, z.B. im Lithographieverfahren, mittels Dünnschichttechnik, Ätztechnik oder andere, dem Fachmann bekannte Herstellungsverfahren.

Der besondere Vorteil einer solchen Konstruktion, bei der ein Verbindungsmaterial vor dem eigentlichen Bonden auf dem einen oder anderen Element (Chip/Substrat) angebracht wird liegt darin, dass sich das Verbindungsmaterial schon beim Bonden zwischen den beiden Bondelementen befindet und nicht erst nachträglich durch Unterfüllen zwischen die Bondpartner gebracht werden muss. Dementsprechend können die Abstände zwischen den Kontaktelementen bzw. zwischen Chip und Substrat beliebig klein ausgeführt werden. Desweitern kann der Verfahrensschritt des Unterfüllens entfallen, was sowohl zu Kostenersparnis als auch zu kürzeren Zykluszeiten führt.

Neben der Alternative, das Verbindungsmaterial vor dem Bonden auf das Substrat aufzubringen, wird bevorzugt das Verbindungsmaterial vor dem Bonden auf der Seite des Flip-Chips aufgebracht, die beim Bonden dem Substrat zugewandt ist. Idealerweise kann das Aufbringen des Verbindungsmaterial schon bei der Herstellung des Chips erfolgen.

Das Verbindungsmaterial kann so ausgelegt werden, dass dessen Höhe über der Chip-Grundfläche geringer ist, als die Höhe der Kontaktelemente des Chips. Die Höhe kann z.B. 5 bis 9 Mikrometer beträgen, wenn die Kontaktelemente eine Höhe von wenigstens 15 Mikrometern aufweisen. Dies hat den Vorteil, dass beim Prozessschritt des Bondens zunächst die Stirnflächen der Kontaktelemente des Chips mit den korrespondierenden Kontaktflächen des Substrates in Kontakt kommen, so daß zunächst eine Konzentration der Ultraschall-Einleitung auf diese Stellen erfolgt.

Die geringere Höhe des Verbindungsmaterials im Vergleich zu den Kontaktelementen des Chips kann auch realisiert werden, wenn das Verbindungsmaterial auf dem Substrat statt auf dem Flip-Chip gemäß der erstgenannten Alternative aufgebracht ist. In diesem Fall wird das Verbindungsmaterial auf dem Substrat über die Kontaktflächen hinausragen, und insbesondere hierbei bevorzugt eine Höhe aufweisen, die geringer ist als die Höhe der Kontaktelemente eines auf dem Substrat anzubringenden Chips, um den obengenannten Vorteil zu erreichen.

Durch Anlegen einer Andruckkraft und einer Ultraschallschwingung wird sodann die elektrische Verbindung zwischen Flip-Chip und Substrat hergestellt, wobei sich die Kontaktelemente verformen und zusammengepresst werden. Hierbei verringert sich der Abstand zwischen Flip-Chip und Substrat, so dass dann erst das Verbindungsmaterial mit dem Substrat oder einer weiteren Verbindungsmaterialschicht auf dem Substrat in Berührung kommt.

Es kann dann vorgesehen sein, dass schon durch die Berührung eine feste Verbindung zwischen Flip-Chip und Substrat erfolgt, z.B. durch eine Klebewirkung zwischen Verbindungsmaterial und Substrat oder durch eine Klebewirkung zwischen den jeweiligen Verbindungsmaterialien auf Chip und Substrat, die einen zweikomponentigen Kleber bilden.

Alternativ kann es auch vorgesehen sein, dass sich die sichere Verbindung zwischen Chip und Substrat erst nach einer Ultraschallverschweissung des Verbindungsmaterials mit dem gegenüberliegenden Partnerelement (Substrat, Chip oder weiteres Verbindungsmaterial) ergibt. In diesem Fall ist der komplette Bondprozess z.B. zweistufig, wobei in der ersten Stufe die elektrisch leitende Ultraschallverbindung zwischen Kontaktelementen und-flächen und anschliessend die zusätzliche Verbindung hergestellt wird. Es ist möglich, dass die beiden Stufen zeitgleich erfolgen.

Bei einer Abfolge der Verschweissung in zeitlich aufeinander folgenden Stufen kann es vorgesehen sein, dass die Verschweissung des Verbindungsmaterials mit anderen Schweissparametern, insbesondere mit einer anderen Ultraschallfrequenz und/oder Andruckkraft, erfolgt, als bei der Verschweissung der Kontaktelemente. So können für jeden Prozessschritt die optimalen Schweissparameter ausgewählt werden.

In einer Weiterbildung der Erfindung kann es vorgesehen sein, dass das Verbindungsmaterial, sei es auf dem Chip oder dem Substrat angebracht, Materialaussparungen, insbesondere in Form von Kanälen oder Rillen aufweist. Diese Aussparungen oder Kanäle/Rillen dienen dazu, Material z.B. sowohl der Kontaktelemente als auch z.B. des Verbindungsmaterials aufzunehmen, welches durch das Bonden verpresst wird. Dieses verpresste Material findet Platz in den Aussparungen/Kanälen ohne dass sich elektrische Fehlkontakte ausbilden.

Das Verbindungsmaterial kann flächig oder auch nur punktuell zwischen den Kontaktelementen (Chip) bzw. Kontaktflächen (Substrat) angeordnet sein. Bei einer flächigen Anordnung ist es bevorzugt vorgesehen, dass das Verbindungsmaterial die Kontaktelemente bzw. Kontaktflächen, insbesondere in einem Abstand, umgibt.

Durch den bevorzugten Abstand wird wiederum ein Bereich oder Kanal ausgebildet, der eine Kontaktfläche bzw. ein Kontaktelement umgibt und dazu dient spannungs- und kräftefrei sowohl Material der Kontaktelemente als auch das Verbindungsmaterials bei der Verpressung bzw. Verformung beim Bonden aufzunehmen. Dieser Bereich/Kanal kann auch eine Isolation zwischen Kontaktelement/-fläche und dem Verbindungsmaterial bilden, insbesondere wenn das Verbindungsmaterial als elektrisch leitendes Material ausgebildet ist, um so ungewollte Kurzschlüsse zwischen den Kontaktelementen/-flächen und dem Verbindungsmaterial zu vermeiden.

Insbesondere bei einer alternativen Ausbildung des Verbindungsmaterial als elektrisch leitendes Material kann durch das Verbindungsmaterial auf sehr einfache Weise eine wenigstens bereichsweise flächige elektrische Verbindung zwischen Substrat und Chip bzw. der darin angeordneten Elektronik realisiert werden. Eine solche flächige Verbindung, von der mehrere unabhängig voneinander vorgesehen sein können, kann z.B. zur Zuführung einer oder mehrerer Versorgungsspannungen oder auch des Massepotential vorgesehen sein. Hierdurch kann die bekannte Notwendigkleit umgangen werden, gerade bei Hochleistungschips eine Fülle von Kontaktelementen nur zur Zuführung von Versorgungsspannungen und Masse zu benutzen.

Derartige durch leitendes Verbindungsmaterial realisierte elektrische Verbindungen zwischen Chip und Substrat können in beliebigen Formen auf dem Chip bzw. Substrat realisiert sein, z.B. kann eine mäanderförmige Verbindung sich zwischen den Kontaktelementen/-flächen erstrecken.

Ebenso kann es vorgesehen sein, dass Kontaktelemente/-flächen der Chips oder des Substrates durch Verbindungsmaterial ersetzt werden, insbesondere die elektrischen Kontakte zur Zuführung von Versorungsspannung und Massepotential können bei dieser Ausführung in Entfall kommen.

Ein Ausführungsbeispiel der Erfindung ist in den nachfolgenden Abbildungen dargestellt. Es zeigen:
- Figur 1:: eine Aufsicht auf die Unterseite eines Flip-Chips.
- Figur 2:: eine geschnittene Seitenansicht eines Flip-Chips;

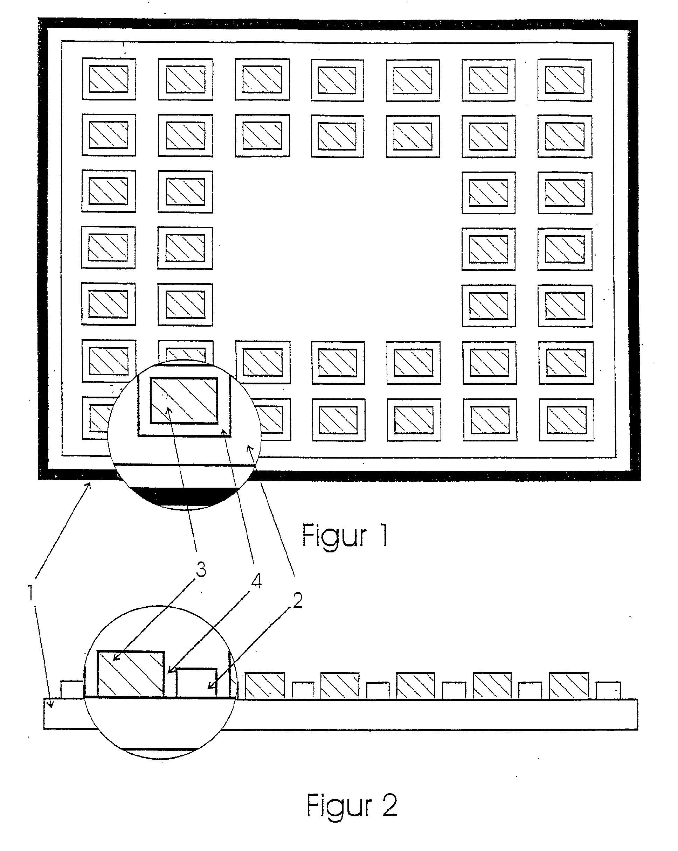

Die Abbildungen 1 und 2 zeigen, dass als Ersatz für den Underfill als Verbindungsmaterial zwischen Chip 1 und einem nicht dargestellten Substrat z.B. ein ultraschallverschweißbarer Kunststoff 2, insbesondere in Bereichen zwischen den Kontaktelementen 3 (Bondpads), eingesetzt ist.

Alternativ hierzu kann auch ein Kleber, insbesondere Zweikomponentenkleber verwendet werden, der auf beiden Verbindungspartnern aufgebracht ist (staubtrocken), und dessen Klebewirkung erst einsetzt, wenn beide Seiten in Kontakt treten, d.h., wenn die metallischen Kontaktelemente 3 entsprechend verformt sind. Desweiteren kann das Verbindungsmaterial auch eine ultraschallverschweißbare Kunststoffbeschichtung sein, die als letzte Maske beim Waferprozess verwendet wurde.

Im vorliegenden Ausführungsbeispiel ist das Verbindungsmaterial 2 flächig zwischen den Kontaktelementen 3 angeordnet. Zwischen den Kontaktelementen 3 und dem Verbindungsmaterial 2 werden Zwischenräume 4 oder Kanäle 4 belassen, die beim Verschweissen mit Ultraschall Platz für verformtes Material, sowohl von den Kontaktelementen 3 als auch des Verbindungsmaterials 2 zur Verfügung stellen, welches sich beim Schweissen plastisch verformt und seitlich ausweicht.

Vorteilhaft ist es, wenn bei der Bearbeitung des Wafers bereits zusätzliches Material als Verbindungsmaterial 2 nach dem "Plating" aufgebracht wird, so dass der Prozessschritt "UNDERFILL" überflüssig ist und die mechanische Festigkeit der Verbindung zwischen Chip 1 und Substrat entweder durch Einwirken von Ultraschall oder durch einen chemischen Prozess, der nach Erzeugen der elektrisch leitenden Verbindung, d.h. nach Verformen der Kontaktelemente bis zur ganzflächigen Berührung in Aktion tritt.

Damit beim Ultraschallschweissen zunächst die elektrischen Kontakte hergestellt werden und anschliessend erst die Verklebung/Verschweissung stattfindet, ist es hier vorteilhaft vorgesehen, dass das Verbindungsmaterial 2 eine geringere Höhe aufweist, als die Kontaktelemente 3. Auch ist es vorgesehen, beim Herstellen der elektrischen Kontakte und der zusätzlichen Verbindung mit verschiedenen Ultraschallenergien und/oder Ultraschallfrequenzen zu arbeiten.

Gegenüber der Verwendung von anisotropen Leitklebern hat das erfindungsgemäße Verfahren den Vorteil, dass die Verbindung niederohmiger ist, da keine stochastisch angeordneten Silberspäne als Strompfad verwendet werden, sondern das Verbindungsmaterial einen direkten Kontakt zwischen Chip und Substrat herstellt.

Ferner ist das erfindungsgemäße Verfahren für kleine Kontaktabstände/Pitches verwendbar, wohingegen bei anisotropen Leitklebern eine kleinste mittlere Weglänge eingehalten werden muss, um eine Isolation sicherzustellen.

## Patentansprüche

1. Chip/Substrat(1) mit mehreren Kontaktelementen/-flächen (3) zur Herstellung einer elektrisch leitenden Verbindung zwischen einem Chip (1) und einem Substrat, insbesondere mittels Ultraschallverschweissung, **dadurch gekennzeichnet, dass** auf der dem Substrat/Chip zugewandten Seite des Chips/Substrats (1) zwischen den Kontaktelementen/-flächen (3) wenigstens bereichsweise ein, insbesondere ultraschallschweißbares, Verbindungsmaterial (2) angeordnet ist.

2. Chip oder Substrat nach Anspruch 1, **dadurch gekennzeichnet, dass** die Höhe des Verbindungsmaterials (2) geringer ist, als die Höhe der Kontaktelemente (3) des Chips (1).

3. Chip oder Substrat nach einem der vorherigen Ansprüche, **dadurch gekennzeichnet, dass** das Verbindungsmaterial (2) Materialaussparungen (4), insbesondere in Form von Kanälen und/oder Rillen (4) aufweist.

4. Chip oder Substrat nach einem der vorherigen Ansprüche, **dadurch gekennzeichnet, dass** das Verbindungsmaterial (2) ein Kontaktelement (3)/ eine Kontaktfläche, insbesondere in einem Abstand umgibt.

5. Chip oder Substrat nach Anspruch 4, **dadurch gekennzeichnet, dass** durch einen Abstand zwischen Verbindungsmaterial (2) und Kontaktelement (3)/fläche ein Kanal (4)/eine Rille ausgebildet ist, der/die ein Kontaktelement (3) / eine Kontaktfläche umgibt und insbesondere gegen das Verbindungsmaterial isoliert.

6. Chip oder Substrat nach einem der vorherigen Ansprüche, **dadurch gekennzeichnet, dass** das Verbindungsmaterial (2) mittels Ultraschall verschweissbar ist und insbesondere wenigstens bereichsweise eine flächige elektrisch nichtleitende oder leitende Verbindung zwischen Chip und Substrat bildet.

7. Chip oder Substrat nach einem der vorherigen Ansprüche, **dadurch gekennzeichnet, dass** das Verbindungsmaterial (2) ein Kleber ist, insbesondere wobei der Chip (1) und das Substrat auf ihren einander zugewandten Seiten jeweils einen Teil eines zweikomponentigen Klebers (2) aufweisen.

8. Verfahren zum Verbinden eines Chips (1), insbesondere nach einem der vorherigen Ansprüche, mit einem Substrat, bei dem zwischen den Kontaktelementen (3) des Chips (1) und den korrespondierenden Kontaktelementen (3) /Kontaktflächen des Substrats eine Ultraschall-Schweissverbindung hergestellt wird, **dadurch gekennzeichnet, dass** mittels eines zwischen den Kontaktelementen (3) des Chips (1) und/oder zwischen den Kontaktflächen eines Substrates angeordneten Verbindungsmaterials (2) eine weitere Verbindung zwischen dem Substrat und dem Chip (1) hergestellt wird.

9. Verfahren nach Anspruch 8, **dadurch gekennzeichnet, dass** die zusätzliche Verbindung durch eine Ultraschall-Verschweissung des Verbindungsmaterials (2) mit dem Chip (1) / Substrat erfolgt.

10. Verfahren nach einem der vorherigen Ansprüche, **dadurch gekennzeichnet, dass** die Verschweissung des Verbindungsmaterials (2) mit anderen Schweissparametern, insbesondere mit einer anderen Ultraschallfrequenz und/oder Andruckkraft, erfolgt als bei der Verschweissung der Kontaktelemente (3).

11. Verfahren nach einem der vorherigen Ansprüche, **dadurch gekennzeichnet, dass** bei der Verschweissung und/oder Verklebung Material des Verbindungsmaterials (2) und/oder des Kontaktelementenmaterials (3) in die Materialaussparungen (4) bzw. Kanäle/Rillen (4) verpresst wird.

12. Verfahren nach einem der vorherigen Ansprüche, **dadurch gekennzeichnet, dass** durch das Verbindungsmaterial eine zumindest bereichsweise flächige leitende Verbindung zwischen Chip und Substrat erzeugt wird.
